(19) **Europäisches Patentamt European Patent Office Office européen des brevets**

(11) **EP 3 407 483 B1**

(12) **EUROPEAN PATENT SPECIFICATION**

(45) Date of publication and mention of the grant of the patent:
**11.10.2023 Bulletin 2023/41**

(21) Application number: **16886500.4**

(22) Date of filing: **16.12.2016**

(51) International Patent Classification (IPC):
**B60L 3/00** (2019.01) **H02P 27/06** (2006.01)

(52) Cooperative Patent Classification (CPC):
**B60L 3/0038; B60L 50/51; H02P 27/06;**
B60L 3/0069; B60L 15/02; B60L 2210/40;
B60L 2220/14; B60L 2240/429; B60L 2240/529;
Y02T 10/64; Y02T 10/70; Y02T 10/72

(86) International application number:
**PCT/JP2016/087465**

(87) International publication number:
**WO 2017/126261 (27.07.2017 Gazette 2017/30)**

(54) **DIRECT CURRENT SENSOR, ALTERNATING CURRENT SENSOR, AND INVERTER COMPRISING SAME**

GLEICHSTROMSENSOR, WECHSELSTROMSENSOR UND WECHSELRICHTER DAMIT

CAPTEUR DE COURANT CONTINU, CAPTEUR DE COURANT ALTERNATIF, ET ONDULEUR LES COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.01.2016 JP 2016006756**

(43) Date of publication of application:
**28.11.2018 Bulletin 2018/48**

(73) Proprietor: **Hitachi Astemo, Ltd.**
**Hitachinaka-shi, Ibaraki 312-8503 (JP)**

(72) Inventors:
• **MITSUI Toshisada**
 **Hitachinaka-shi**
 **Ibaraki 312-8503 (JP)**
• **MIYAZAKI Hideki**
 **Hitachinaka-shi**
 **Ibaraki 312-8503 (JP)**
• **YAHATA Koichi**
 **Hitachinaka-shi**
 **Ibaraki 312-8503 (JP)**
• **HOSHINO Katsuhiro**
 **Hitachinaka-shi**
 **Ibaraki 312-8503 (JP)**

(74) Representative: **MERH-IP Matias Erny Reichl Hoffmann**
**Patentanwälte PartG mbB**
**Paul-Heyse-Strasse 29**
**80336 München (DE)**

(56) References cited:
CN-A- 103 684 201  DE-A1- 4 439 932
JP-A- H0 984 359  JP-A- H07 135 797
JP-A- S59 149 776  JP-A- 2001 023 842
JP-A- 2004 032 917  JP-A- 2004 212 201
JP-A- 2006 170 677  JP-A- 2013 130 440
JP-A- 2015 097 472  US-A1- 2014 265 967

**Description**

Technical Field

The present invention relates to a direct-current sensor and an alternating-current sensor that detect a current supplied to a motor used in a hybrid electric vehicle (HEV) or electric vehicle (EV), and an inverter having these sensors. The present invention relates more particularly to a direct-current sensor, an alternating-current sensor, and an inverter that are best suited to an electric motor drive device that drives a permanent magnet synchronous motor in which armature winding wires of a stator of the motor are independent in individual phases.

Background Art

Hybrid electric vehicles and electric vehicles are limited in battery capacity. A voltage for driving a motor has a limited value in accordance with the number of batteries connected in series and a charging state. The motor for running a hybrid electric vehicle or electric vehicle is mainly a permanent magnet synchronous motor, and specifically, an interior permanent magnet motor (IPM) that satisfies the demand for low speed, high torque, and a wider rotation speed region is used.

In the permanent magnet synchronous motor, a magnet flux of the permanent magnet attached to the rotor is interlinked with the armature winding wires to induce a voltage in the armature winding wires. With increase in rotation speed, the induced voltage becomes higher. Thus, a motor drive device needs to control the current to the motor to generate necessary torque while suppressing the induced voltage. Accordingly, the operation of the motor is limited by a direct-current voltage of the battery.

To further increase an AC voltage to the motor with a limitation on the direct-current voltage of the battery, there is known a drive device for an open-winding motor in which the winding wires of a stator of the motor in individual phases are independent from each other. The drive device for an open-winding motor allows increase in output capacity.

There is also known a method for determining quality of current sensors for use in a motor drive device by the sum of detection values of three AC currents (see PTL 1). This method is based on Kirchhoff's law, that is, the law under which the sum of currents flowing into and out of a circuit is zero. Furthermore, PTL 2 discloses an inverter apparatus which converts direct current to alternating current to drive an alternating current motor, wherein an AC motor is provided which includes an armature winding in open delta connection connected in series between an AC output terminal of a first inverter and an AC output terminal of a second inverter. PTL 3 discloses a current detector, wherein a control circuit is provided that outputs a signal to switch on and off the semiconductor switches comprising an inverter continuously and outputs a signal to switch off all the semiconductor switches when the overcurrent detection signal is input. PTL 4 discloses a fault detection circuit for an inverter device, wherein a Hall IC is provided in the vicinity of a pair of parallel wiring patterns through which a reciprocating current flows, to facilitate detecting a ground fault. Eventually, PTL 5 discloses a rectifier circuit for converting AC power from an AC power source into DC power, wherein comparison means for comparing the current value detected by the current detection means with a reference value, and decision means for outputting an abnormal signal to said control means based on the comparison result by the comparison means is provided, wherein said control means switches off the switching element when the abnormal signal is input, thereby stopping the AC output of the inverter circuit.

Citation List

Patent Literature

    PTL 1: JP H9-23501 A
    PTL 2: DE 44 39 932 A1
    PTL 3: JP S59 149 776 A
    PTL 4: JP 2006 170 677 A
    PTL 5: JP H09 843 59 A

Summary of Invention

Technical Problem

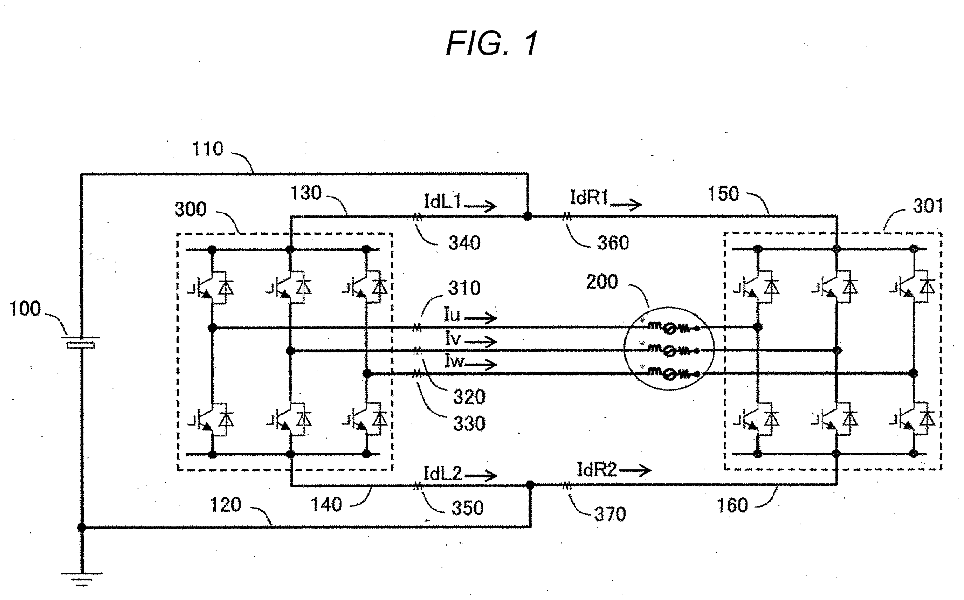

The drive device for an open-winding motor will be described with reference to a wiring diagram of an electric motor drive device according to a related technique described in FIG. 1. FIG. 1 is a diagram for describing a diagnostic principle for current sensors in the electric motor drive device.

In the electric motor drive device, an AC current flows from a three-phase inverter 300 into a motor 200, and then flows into another three-phase inverter 301. In addition, the three-phase inverter 300 and the three-phase inverter 301 exchange bus current via connecting wires 340, 360, 350, and 370 connecting a P bus and an N bus. Therefore, quality of the current sensors cannot be determined only with detection values Iu, Iv, and Iw of the three AC currents. To capture the sum of the currents flowing into and out of the circuit, it is necessary to detect the currents flowing into and out of the P bus and the N bus as well as the three AC currents.

A current to a P bus connecting wire 340 is designated as IdL1, a current to the P bus connecting wire 360 as IdR1, a current to the N bus connecting wire 350 as IdL2, and a current to the N bus connecting wire 370 as IdR2 .

From the foregoing, the following Mathematical Formulas (1) and (2) hold and thus (Iu + Iv + Iw) is not basically zero.

[Mathematical Formula 1]

$$Iu + Iv + Iw + IdL1 + IdL2 = 0 \quad ... \quad (1)$$

[Mathematical Formula 2]

$$Iu + Iv + Iw + IdR1 + IdR2 = 0 \quad ... \quad (2)$$

All the currents described in Mathematical Formula (1) or (2) are detected and the sum of them is determined. When the sum of the currents falls within a threshold taking sensor accuracy and detection timing gaps into account, all the current sensors are judged as good. When the sum of currents exceeds the threshold, any of the current sensors is judged as not good. The 0-axis current of a motor is generally defined by Mathematical Formula (3), which is combined with Mathematical Formulas (1) and (2) into Mathematical Formula (4) as follows:

[Mathematical Formula 3]

$$I_z \quad = \frac{1}{\sqrt{3}} \cdot \quad (Iu + Iv + Iw) \quad \cdot \cdot \cdot \quad (3)$$

[Mathematical Formula 4]

$$-\sqrt{3} \cdot I_z \quad = \quad IdL1 + IdL2 \quad = \quad IdR1 + IdR2 \cdot \cdot \cdot \quad (4)$$

As a result, the 0-axis current of the motor can be obtained by calculating (Iu + Iv + Iw) or by detecting (IdL1 + IdL2) or (IdR1 + IdR2). The following description is based on a set of currents (IdL1 + IdL2).

An object of the present invention is to determine accurately the quality of current sensors. The current IdL1 includes part of the motor 0-axis current and a current derived from the direct-current power source. The current IdL2 includes the remainder of the motor 0-axis current and a current of the opposite polarity derived from the direct-current power source. This can be expressed by Mathematical Formulas (5), (6), and (7) as follows:

[Mathematical Formula 5]

$$IdL1 = IdL + A \quad ... \quad (5)$$

[Mathematical Formula 6]

$$IdL2 = -IdL + B \quad ... \quad (6)$$

[Mathematical Formula 7] where

$$-\sqrt{3} \cdot I_z = A + B \cdots (7)$$

To detect the two currents, it is necessary to prepare two current sensors with relatively large capacity. The accuracy of a current sensor is specified by ratio, and becomes lowered at the detection of a large current. Accordingly, the accuracy of determination on the quality of current sensors becomes reduced.

Another object of the present invention is size and cost. The number of current sensors is preferably small to make the electric motor drive device compact in size. In addition, the number of current sensor is preferably small from the viewpoint of cost as well.

Solution to Problem

The problem is solved by the appended set of claims. Preferably embodiments are claimed by the dependent claims.

According to the present invention, one current sensor detects a set of currents (IdL1 and IdL2), which makes it possible to cancel out the current derived from the direct-current power source and obtain only the 0-axis current.

Advantageous Effects of Invention

According to the present invention, the capacity of the current sensor only needs to match the 0-axis current, which makes it possible to detect accurately the direct currents for driving the alternating-current motor. Therefore, it is possible to accurately determine the quality of the current sensors. In addition, two current sensors can be reduced to one, which makes the electric motor drive device compact in size and allows cost reduction. Another advantageous effect of the present invention is to detect accurately the 0-axis current and control accurately the 0-axis current.

Brief Description of Drawings

[FIG. 1] FIG. 1 is a wiring diagram of a conventional electric motor drive device.
[FIG. 2] FIG. 2 is a wiring diagram of an electric motor drive device according to the present invention.
[FIG. 3] FIG. 3 is a wiring diagram of an electric motor drive device according to Example 1 of the present invention. It is noted that Example 1 is not encompassed by the wording of the claims but is considered as useful for understanding the invention.
[FIG. 4] FIG. 4 is a wiring diagram of an electric motor drive device according to Example 2 of the present invention. It is noted that Example 2 is not encompassed by the wording of the claims but is considered as useful for understanding the invention.
[FIG. 5] FIG. 5 is a perspective view of a specific example of a current sensor.

Description of Embodiments

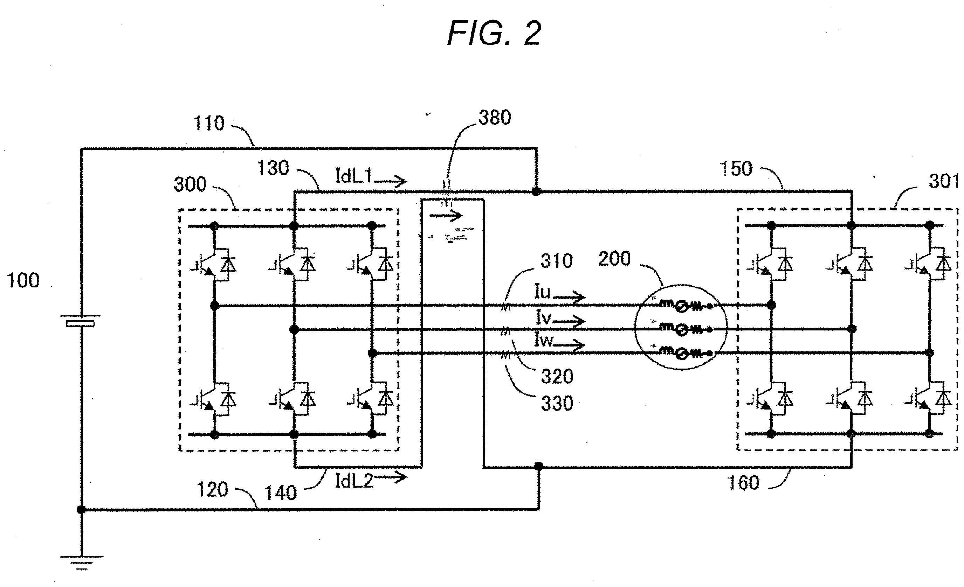

(System configuration) FIG. 2 is a wiring diagram of an electric motor drive device according to the present invention, which describes the current detection positions at which Kirchhoff's law holds in the present invention.

An electric motor drive device according to the present invention is a drive device for an open-winding motor, which has a battery 100, an open-winding motor 200, and two three-phase inverters 300 and 301.

The battery 100 is connected to P bus connecting wires 130 and 150 via a plus direct-current power cable 110. The battery 100 is also connected to N bus connecting wires 140 and 160 via a minus direct-current power cable 120. The P bus connecting wire 130 and the N bus connecting wire 140 connect to a P bus and an N bus of the three-phase inverter 300. The P bus connecting wire 150 and the N bus connecting wire 160 connect to a P bus and an N bus of the three-phase inverter 301. With the foregoing connections, the battery 100 and the three-phase inverters 300 and 301 exchange direct-current power.

The three-phase inverter 300 and the open-winding motor (alternating-current motor) 200 connect to each other to exchange AC power. Similarly, the three-phase inverter 301 and the open-winding motor 200 connect to each other to exchange AC power. In this manner, the three-phase inverters 300 and 301 include switching circuit units that convert a direct current into an alternating current.

The open-winding motor 200 externally exchanges mechanical output via a mechanical output shaft not illustrated. The open-winding motor 200 also includes a rotation angle sensor not illustrated. Three AC sensors (alternating-current sensors) 310, 320, and 330 are provided between the three-phase inverter 300 and the open-winding motor 200 to detect AC currents (Iu, Iv, and Iw) of respective phases.

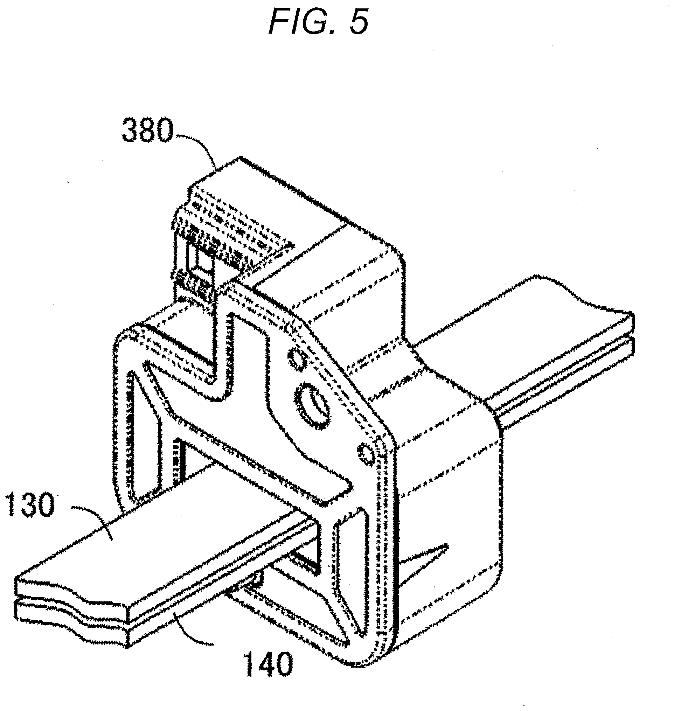

The P bus connecting wire 130 and the N bus connecting wire 140 are partly arranged in proximity to each other, and a DC sensor (direct-current sensor) 380 detects collectively currents (IdL1 and IdL2) flowing to the P bus connecting wire 130 and the N bus connecting wire 140. Specifically, as illustrated in FIG. 5, the P bus connecting wire 130 and the N bus connecting wire 140 are arranged to pass through the core in the DC sensor 380 to obtain the sum of IdL1 and IdL2.

(Principle)

The four sensors 310, 320, 330, and 380 can detect the sum of values of five currents flowing from the three-phase inverter 300. Mathematical Formula (1) can be used under Kirchhoff's law. The value of Iu + Iv + Iw + (IdL1 + IdL2) is evaluated by a threshold taking errors in the current sensors and detection errors resulting from detection timing gaps into account. When the absolute value of the sum of the five currents falls below the threshold, all the current sensors are judged as good. When the absolute value of the sum of the five currents exceeds the threshold, any of the current sensors is judged as not good.

The electric motor drive device illustrated in FIG. 2 has the three-phase inverters 300 and 301 and the DC sensor 380 to drive the alternating-current motor 200. The electric motor drive device has a diagnosis unit that diagnoses a failure of the DC sensor 380 and/or the AC sensor 310, 320, and 330 based on output information from the DC sensor and output signals from the AC sensors. The three-phase inverters 300 and 301 include switching circuit units that convert a direct current into an alternating current, and serve as control units that control the switching circuit units to suppress an error between the 0-phase current in the P bus connecting wire 130 and the 0-phase current in the N bus connecting wire 140 based on the output information from the DC sensor 380.

In this configuration, the currents (IdL1 and IdL2) are collectively detected, and the current derived from the battery (direct-current power source) is canceled out as described above. This makes it possible to use a current sensor with a capacity suitable to √3 times the 0-axis current, without the need to use a larger-capacity current sensor allowing for the current derived from the battery (direct-current power source). Accordingly, the detection error between the currents (IdL1 + IdL2) can be reduced as compared to that in the case where two current sensors detect separately the two currents. This makes it possible to decrease the threshold and improve the accuracy of determination on the quality of the current sensors. In addition, two current sensors for measuring direct currents can be reduced to one, which makes the drive device compact in size and allows cost reduction.

The 0-axis current can be detected by multiplying the currents (IdL1 + IdL2) by a coefficient. When the three AC currents Iu, Iv, and Iw are separately detected and the 0-axis current is determined from the sum of them, the accuracy of the detection becomes lowered with errors in the three current sensors and errors resulting from gaps in current detection timing. In the configuration of the present invention, an error in the 0-axis current can be controlled by an error in one current sensor to improve the accuracy of the 0-axis current. The 0-axis current can be accurately controlled by using this detection value.

[Example 1]

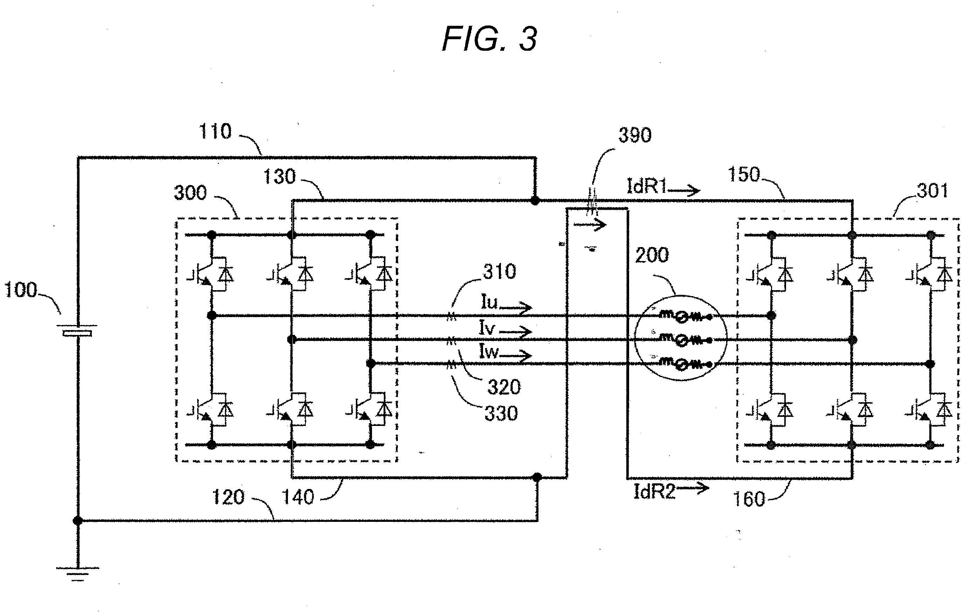

FIG. 3 is a wiring diagram of an electric motor drive device according to Example 1 of the present invention. Example 1 is different from the present invention in that, without the DC sensor 380, the P bus connecting wire 150 and the N bus connecting wire 160 are partly arranged in proximity to each other so that a DC sensor 390 detects collectively currents (IdR1 and IdR2) flowing to the P bus connecting wire 150 and the N bus connecting wire 160. The DC sensor 390 has a core surrounding the P bus connecting wire 150 and the N bus connecting wire 160.

The open-winding motor 200 and the three-phase inverter 301 are handled as one circuit that detects the sum of five currents flowing into the circuit, where Kirchhoff's law can be used as well. As for other components, Example 1 is identical to the present invention and thus detailed descriptions thereof will be omitted.

The electric motor drive device illustrated in FIG. 3 has the three-phase inverters 300, 301, and the DC sensor 390 to drive the alternating-current motor 200. The electric motor drive device can diagnose a failure of the DC sensor 390 and/or the AC sensors 310, 320, and 330 based on output information from the DC sensor 390 and output signals from the AC sensors 310, 320, and 330 of respective phases. The three-phase inverters 300 and 301 include switching circuit units that convert a direct current into an alternating current, and control the switching circuit units to suppress an error in the 0-phase current based on the output information from the DC sensor 390.

[Example 2]

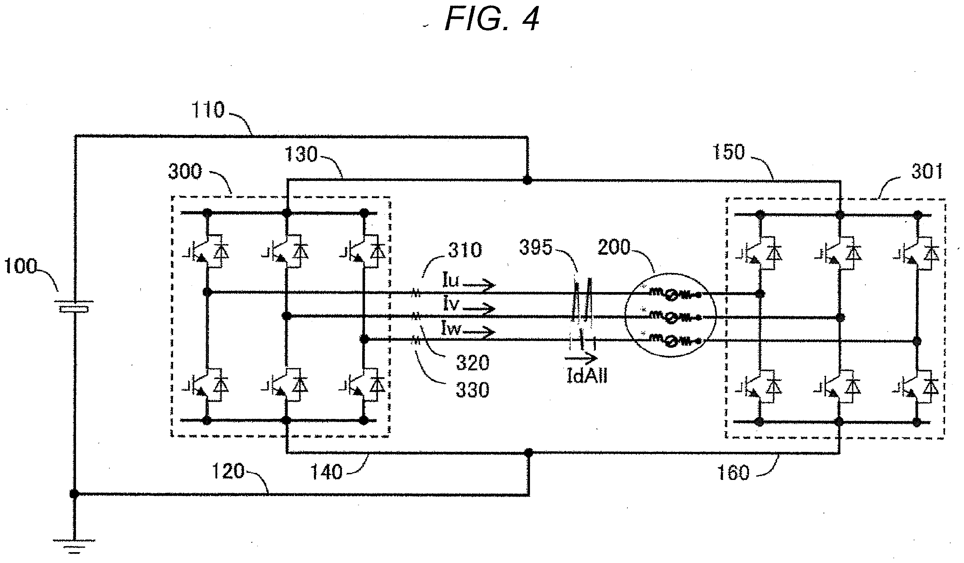

FIG. 4 is a wiring diagram of an electric motor drive device according to Example 2 of the present invention. Example 2 is different from the present invention in that, without the DC sensor 380, an AC sensor 395 detects collectively the three AC values instead. Detection value (IdAll) is equivalent to (IdL1 + IdL2). As for other components, Example 2 is identical to the present invention and thus detailed descriptions thereof will be omitted. The AC sensor 395 has a core surrounding all three alternating-current wires of respective phases flowing currents in the alternating-current motor 200.

The electric motor drive device illustrated in FIG. 4 has the three-phase inverters 300, 301, and the AC sensor 395 to drive the alternating-current motor 200. The electric motor drive device can diagnose a failure of the AC sensor 395 and/or the AC sensors 310, 320, and 330 based on output information from the AC sensor 395 and output signals from the AC sensors 310, 320, and 330 of respective phases. The three-phase inverters 300 and 301 include switching circuit units that convert a direct current into an alternating current, and control the switching circuit units to suppress an error in the 0-phase current based on the output information from the AC sensor 395.

Embodiments of the present invention have been described in detail so far. However, the present invention is not limited to the foregoing embodiments but allows various design changes without deviating from the scope of the present invention claimed in the claims.

Reference Signs List

100 battery (direct-current power source)
110 plus direct-current power cable
120 minus direct-current power cable
130, 150 P bus connecting wire (P connecting wire)
140, 160 N bus connecting wire (N connecting wire)
200 open-winding motor (alternating-current motor)
300, 301 three-phase inverter
310, 320, 330 AC sensors of U, V, and W phases
340, 360 current sensor detecting a current flowing into and out of P bus
350, 370 current sensor detecting a current flowing into and out of N bus
380, 390 current sensor detecting collectively currents flowing into and out of P bus and N bus
395 current sensor detecting collectively AC currents

## Claims

1. An electric drive device, wherein the electric drive comprises:

   - a battery (100),
   - an open-winding motor (200), and
   - at least a first three-phase inverter (300) and a second three-phase inverter (301) each connected to a different side of the open-winding motor (200),
   - three alternating current sensors (310, 320, 330) provided between the one of the three-phase inverters (300, 301) and the open-winding motor (200) to detect alternating currents of respective phases,
   - a first P bus connecting wire (130), a second P bus connecting wire (150), a first N bus connecting wire (140) and a second N bus connecting wire (160), which are partly arranged in proximity to each other, and
   - a direct-current sensor (380, 390) to detect collectively currents (IdL1 and IdL2, IdR1 and IdR2) flowing to the first P bus connecting wire (130) and the first N bus connecting wire (140) or to the second P bus connecting wire (150) and the second N bus connecting wire (160),
   - a diagnosis unit that diagnoses a failure of the direct-current sensor (380, 390) when the sum of currents measured by the direct-current sensor (380, 390) and the currents measured by the alternating-current sensors (310, 320, 330) is above a certain threshold, wherein the direct-current sensor (380, 390) detects direct currents supplied to the first three-phase inverter (300) or the second three-phase inverter (301) for driving the open-winding motor (200),

      wherein the battery (100) is connected to the first three-phase inverter (300) via the first P bus connecting wire (130) and the first N bus connecting wire (140), and to the second three-phase inverter (301) via the second P bus connecting wire (150) and the second N bus connecting wire (160), and the direct-current sensor (380, 390) has a core surrounding the first P bus connecting wire (130) and the first N bus connecting wire (140) or the second P bus connecting wire (150) and the second N bus connecting wire (160).

2. The electric drive device according to one of the preceding claims, outputting information including 0-phase current of the first P bus connecting wire (130) and the first N bus connecting wire (140) and 0-phase current of the second N bus connecting wire (160) and the second P bus connecting wire (150).

3. The electric drive device according to claim 2, comprising:

a switching circuit unit that converts the direct current into the alternating current; and
a control unit that controls the switching circuit unit to suppress the 0-phase currents based on output information from the direct-current sensor (380, 390).

**Patentansprüche**

1. Elektrische Antriebsvorrichtung,

wobei der elektrische Antrieb Folgendes umfasst:

- eine Batterie (100),
- einen Motor mit offener Wicklung (200), und
- mindestens einen ersten Dreiphasen-Wechselrichter (300) und einen zweiten Dreiphasen-Wechselrichter (301), die jeweils mit einer anderen Seite des Motors mit offener Wicklung (200) verbunden sind,
- drei Wechselstromsensoren (310, 320, 330), die zwischen dem einen der Dreiphasen-Wechselrichter (300, 301) und dem Motor mit offener Wicklung (200) vorgesehen ist, um Wechselströme der jeweiligen Phasen zu detektieren,
- eine erste P-Bus-Verbindungsleitung (130), eine zweite P-Bus-Verbindungsleitung (150), eine erste N-Bus-Verbindungsleitung (140) und eine zweite N-Bus-Verbindungsleitung (160), die teilweise in unmittelbarer Nähe zueinander angeordnet sind, und
- einen Gleichstromsensor (380, 390), um die Ströme (IdL1 und IdL2, 1dR1 und IdR2), die zu der ersten P-Bus-Verbindungsleitung (130) und der ersten N-Bus-Verbindungsleitung (140), oder zu der zweiten P-Bus-Verbindungsleitung (150) und der zweiten N-Bus-Verbindungsleitung (160) fließen, gemeinsam zu detektieren,
- eine Diagnoseeinheit, die einen Fehler des Gleichstromsensors (380, 390) diagnostiziert, wenn die Summe der Ströme, die durch den Gleichstromsensor (380, 390) gemessen werden, und der Ströme, die durch die Wechselstromsensoren (310, 320, 330) gemessen werden, oberhalb eines bestimmten Schwellenwertes liegt, wobei der Gleichstromsensor (380, 390) Gleichströme detektiert, die dem ersten Dreiphasen-Wechselrichter (300) oder dem zweiten Dreiphasen-Wechselrichter (301) zum Antreiben des Motors mit offener Wicklung (200) zugeführt werden,

wobei die Batterie (100) mit dem ersten Dreiphasen-Wechselrichter (300) über die erste P-Bus-Verbindungsleitung (130) und die erste N-Bus-Verbindungsleitung (140), und mit dem zweiten Dreiphasen-Wechselrichter (301) über die zweite P-Bus-Verbindungsleitung (150) und die zweite N-Bus-Verbindungsleitung (160) verbunden ist, und
der Gleichstromsensor (380, 390) einen Kern aufweist, der die erste P-Bus-Verbindungsleitung (130) und die erste N-Bus-Verbindungsleitung (140) oder die zweite P-Bus-Verbindungsleitung (150) und die zweite N-Bus-Verbindungsleitung (160) umgibt.

2. Elektrische Antriebsvorrichtung nach einem der vorhergehenden Ansprüche, die Informationen ausgibt, die den 0-Phasen-Strom der ersten P-Bus-Verbindungsleitung (130) und der ersten N-Bus-Verbindungsleitung (140) und den 0-Phasen-Strom der zweiten N-Bus-Verbindungsleitung (160) und der zweiten P-Bus-Verbindungsleitung (150) enthalten.

3. Elektrische Antriebsvorrichtung nach Anspruch 2, die Folgendes umfasst:

eine Schaltschaltungseinheit, die den Gleichstrom in den Wechselstrom umwandelt; und
eine Steuereinheit, die die Schaltschaltungseinheit steuert, die 0-Phasen-Ströme basierend auf Ausgabeinformationen von dem Gleichstromsensor (380, 390) zu unterdrücken.

**Revendications**

1. Dispositif d'entraînement électrique,

   dans lequel le dispositif d'entraînement électrique comprend :

   - une batterie (100),
   - un moteur à bobinage ouvert (200), et
   - au moins un premier onduleur triphasé (300) et un second onduleur triphasé (301) connectés chacun à un côté différent du moteur à bobinage ouvert (200),
   - trois capteurs à courant alternatif (310, 320, 330) prévus entre l'un des trois onduleurs triphasés (300, 301) et le moteur à bobinage ouvert (200) pour détecter des courants alternatifs de phases respectives,
   - un premier fil de connexion bus P (130), un second fil de connexion bus P (150), un premier fil de connexion bus N (140) et un second fil de connexion bus N (160), qui sont agencés en partie à proximité les uns des autres, et
   - un capteur à courant continu (380, 390) pour détecter collectivement des courants (IdL1 et IdL2, IdR1 et IdR2) s'écoulant jusqu'au premier fil de connexion bus P (130) et au premier fil de connexion bus N (140) ou jusqu'au second fil de connexion bus P (150) et au second fil de connexion bus N (160),
   - une unité de diagnostic qui établit un diagnostic de panne du capteur à courant continu (380, 390) quand la somme des courants mesurés par le capteur à courant continu (380, 390) et des courants mesurés par le capteur à courant alternatif (310, 320, 330) est au-dessus d'un certain seuil, dans lequel le capteur à courant continu (380, 390) détecte des courants continus alimentés au premier onduleur triphasé (300) ou au second onduleur triphasé (301) pour entraîner le moteur à bobinage ouvert (200),

   dans lequel la batterie (100) est connectée au premier onduleur triphasé (300) via le premier fil de connexion bus P (130) et le premier fil de connexion bus N (140), et au second onduleur triphasé (301) via le second fil de connexion bus P (150) et le second fil de connexion bus N (160), et
   le capteur à courant continu (380, 390) a un noyau entourant le premier fil de connexion bus P (130) et le premier fil de connexion bus N (140) ou le second fil de connexion bus P (150) et le second fil de connexion bus N (160).

2. Dispositif d'entraînement électrique selon l'une des revendications précédentes, qui sort des informations incluant un courant de phase 0 du premier fil de connexion bus P (130) et du premier fil de connexion bus N (140) et un courant de phase 0 du second fil de connexion bus N (160) et du second fil de connexion bus P (150).

3. Dispositif d'entraînement électrique selon la revendication 2, comprenant :

   une unité de circuit de commutation qui convertit le courant continu en courant alternatif ; et
   une unité de commande qui commande l'unité de circuit de commutation pour supprimer les courants de phase 0 sur la base des informations de sortie provenant du capteur à courant continu (380, 390).

FIG. 1

FIG. 2

FIG. 3

EP 3 407 483 B1

## FIG. 4

EP 3 407 483 B1

# FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H923501 A
- DE 4439932 A1
- JP 59149776 A
- JP 2006170677 A
- JP H0984359 A